# EUROPÄISCHE PATENTSCHRIFT

(11) **EP 2 122 671 B1**
(45) Veröffentlichungstag und Bekanntmachung des Hinweises auf die Patenterteilung: **13.04.2016**
(21) Anmeldenummer: 08716142.8
(22) Anmeldetag: 20.02.2008
(51) Int. Cl.: H01L 27/08, H01L 29/66, H01L 27/06, H01L 29/94, H01L 49/02

(54) **HALBLEITERANORDNUNG MIT GRABENKONDENSATOR UND VERFAHREN ZU DEREN HERSTELLUNG**
SEMICONDUCTOR ARRANGEMENT WITH TRENCH CAPACITOR AND METHOD FOR PRODUCTION THEREOF
DISPOSITIF À SEMI-CONDUCTEURS COMPORTANT UN CONDENSATEUR À TRANCHÉES ET PROCÉDÉ DE FABRICATION

(30) Priorität: 20.02.2007 DE 102007009383
(43) Veröffentlichungstag der Anmeldung: 25.11.2009
(73) Patentinhaber: Fraunhofer-Gesellschaft zur Förderung der angewandten Forschung e.V., 80686 München (DE)
(72) Erfinder: MARENCO, Norman, 25582 Hohenaspe (DE)
(74) Vertreter: Pfenning, Meinig & Partner mbB
(86) Internationale Anmeldenummer: PCT/EP2008/001619
(87) Internationale Veröffentlichungsnummer: WO 2008/101738

(56) Entgegenhaltungen:
- WO-A-2007/005141
- FR-A- 2 832 855
- JP-A- 2 199 862
- US-A- 5 811 868
- US-A1- 2005 029 623
- US-B1- 6 236 103
- US-B1- 6 614 645

## Beschreibung

Die Erfindung betrifft eine Halbleiteranordnung nach dem Oberbegriff des Hauptanspruchs, sowie ein Verfahren zur Herstellung einer derartigen Halbleiteranordnung.

In der Elektronik ist es üblich, so genannte Stütz- oder Pufferkondensatoren einzusetzen, die zumeist nahe an einem bestimmten Bauteil platziert werden müssen und deren Aufgabe es ist, kurze Strompulse aus den Zuleitungen zu filtern. Diese Stützkondensatoren sind insbesondere bei integrierten Schaltungen üblich und selten vermeidbar.

So können beispielsweise bei der synchronen Taktung von Prozessoren und anderen Logikschaltungen periodisch sehr hohe Stromspitzen auftreten, in welchen die internen Transistoren gleichzeitig geschaltet werden. Ohne eine Pufferung der Energieversorgung nahe am Bauelement würden die Stromimpulse aufgrund des Ohmschen Gesetzes einen hohen Spannungsabfall über die Versorgungszuleitung hervorrufen. Dieser würde sich als kurzzeitiger Einbruch der Betriebsspannung auswirken, wodurch ein zuverlässiger Betrieb des Bauelementes nicht mehr sichergestellt werden könnte.

In einer anderen Anwendung werden Stützkondensatoren eingesetzt, um bei der Erfassung eines Spannungswertes durch ein Bauelement die durch das Bauelement entnommene Ladungsmenge aus dem Signal selbst wieder auszugleichen. Dadurch führt der kurze Stromimpuls des Bauelements nicht zu einer starken Spannungsänderung.

Gegenwärtig werden Stütz- und Pufferkondensatoren als diskrete, passive Bauteile ausgeführt, in denen ein oder mehrere Kondensatoren realisiert sind. Diese werden um die integrierte Schaltung herum gruppiert. Der Flächenbedarf ist dabei erheblich, da oftmals 20 oder mehr solcher separater Bauteile erforderlich sind.

Mit der zunehmenden Integrationsdichte elektronischer Bauteile werden die Gehäuse von integrierten Halbleiterschaltungen immer kleiner. Man spricht dabei von Chip Scale Packages, bei denen das Gehäuse nur noch wenig größer als der Halbleiterchip selbst ist. Für den Aufbau der Baugruppe bedeutet dies, dass der Flächenbedarf von passiven Bauteilen die weitere Miniaturisierung einschränkt und den Entwickler vor Probleme bei der Entflechtung der Signale im Umfeld der integrierten Schaltung stellt. Weiterhin stellen die passiven Bauteile einen nicht wesentlich reduzierbaren Teil der Produktkosten dar.

Die Druckschrift US2006/0131691 A1 versucht das Problem dadurch zu lösen, dass die Pufferkondensatoren in Gräben auf der der eigentlichen Halbleiterschaltung abgewandten Seite des Halbleitersubstrats eingebracht werden. Hierdurch ist es möglich der zunehmenden Miniaturisierung der Halbleiterschaltung Rechnung zu tragen ohne den eingesparten Platz mit Pufferkondensatoren wieder zu füllen. Der Nachteil der dort gezeigten Lösung liegt darin, dass die Gräben nur begrenzt eingebracht werden können ohne eine Schwächung des Substrats zu bewirken. Dies liegt unter anderem daran, dass nach dem Einbringen der Gräben und der darin angeordneten Pufferkondensatoren das Halbleitersubstrat einem erneuten Ätzprozess unterworfen wird um notwendige Opferschichten zu entfernen.
Um die notwendigen Kapazitäten zur Energiespeicherung zur Verfügung zu stellen, müssen große Teile der Rückseite des Substrats mit Kondensatorgräben, welche mittels Tiefenätzungen herstellbar sind, versehen werden. Diese Problematik wird nicht näher diskutiert. Kondensatoranordnungen mit ähnlichen dreidimensionalen Geometrien sind ebenso Gegenstand der Druckschriften US 6 236 103 B1 und WO 2007 005141 A1.

Die der Erfindung zugrunde liegende Aufgabe besteht darin, dass zum einen der Platzbedarf einer Halbleiteranordnung reduziert wird und eine ausreichend hohe Kapazität auf engstem Raum kostengünstig zur Verfügung gestellt wird ohne dabei eine Schwächung des Substrats in Kauf nehmen zu müssen.

Die Aufgabe wird durch die Halbleiteranordnung des Anspruches 1 und das Verfahren zur Herstellung einer derartigen Halbleiteranordnung gelöst.

Die Halbleiteranordnung weist ein Substrat auf, auf dessen Vorderseite eine integrierte Schaltung strukturiert ist. Des Weiteren ist die integrierte Schaltung mit mindestens einem Kondensator zur Energiespeicherung verbunden, wobei der Kondensator auf der Rückseite des Substrats als monolithische Tiefenstruktur mit mindestens zwei Gräben ausgebildet ist.

Die mindestens zwei, vorzugsweise mindestens vier, Gräben sind in einer ersten Gruppe von jeweils parallel zueinander liegenden Gräben und in einer zweiten Gruppe von jeweils parallel zueinander liegenden Gräben ausgebildet, wobei die erste Gruppe und die zweite Gruppe quer zueinander angeordnet sind. Vorzugsweise sind mindestens zwei Gräben je Gruppe vorhanden. Die Bruchfestigkeit des Substrats wird durch die Geometrie der Ätzung sowie dem Verhältnis von Substratdicke zur Ätztiefe reguliert. Auf diese Aspekte wird in den folgenden Abschnitten näher eingegangen.

Der Vorteil der erfindungsgemäßen Halbleiteranordnung besteht zu einen darin, dass durch die Anordnung des Kondensators auf der Rückseite des Substrats dieser Kondensator im integrierten Halbleiterbauelement selbst bereitgestellt und Bestandteil desselben ist. Zum einen kann dadurch die Größe der Baugruppe des Halbleiterchips kleiner gegenüber den Lösungen im Stand der Technik ausfallen, zum anderen ist eine gute Pufferleistung aufgrund des geringen Abstandes zur Schaltanordnung auf der gegenüberliegenden Seite des Substrats möglich. Ein weiterer Vorteil besteht darin, dass durch die Ausbildung des Kondensators als Tiefenstruktur, die zur Verfügung stehende Kondensatoroberfläche gegenüber einer planaren Struktur um ein Vielfaches vergrößert werden kann. Hierbei kann die Oberflächenvergrößerung mit gängigen Techniken, die zur Ausbildung von einem oder mehreren Kondensatoren zur Verfügung stehende Gesamtoberfläche um bis zu zwei Größenordnungen gegenüber der planaren Fläche ausmachen. Mit Hilfe der vergrößerten Oberfläche kann eine Kapazität erreicht werden, die für einen Stütz- bzw. Pufferkondensator notwendig ist, um die in der Einleitung beschriebenen Spannungsspitzen abzufangen. Auf diese Art und Weise kann auf passive Stützkondensatoren, welche nicht auf dem Substrat angeordnet sind, verzichtet werden.

Dadurch dass die Tiefenstruktur monolithisch ausgebildet ist, kann der mindestens eine Kondensator auf der Rückseite des Substrats kostengünstig hergestellt werden. Des Weiteren wird der mindestens eine Kondensator als Teil der Oberfläche des Substrats ausgebildet und bringt dadurch eine weitere Platzersparnis gegenüber den im Stand der Technik bekannten Methoden.

Durch die Anordnung der ersten und zweiten Gruppe zueinander wird vermieden, dass das Substrat in einer Richtung übermäßig stark strapaziert wird und es so zu einem Bruch im Substrat kommen kann.

Bei den Kondensatoren handelt es sich um Kondensatoren zur Energiespeicherung, welche sich aufgrund ihrer höheren Kapazität wesentlich von den Kondensatoren zur Informationsspeicherung unterscheiden.

Bei der Energiespeicherung von Versorgungsspannungen oder digitalen Ein-/Ausgängen eines Mikrochips oder dem Puffern einer analogen Eingangsspannung eines Analog-Digital-Wandlers oder beim Filtern von Spannungen sind Kapazitätswerte zwischen 1 uF und 25pF nötig, welche durch die erfindungsgemäße Halbleiteranordnung zur Verfügung stellen kann.

Vorteilhafte Weiterbildungen des erfindungsgemäßen Gegenstandes sind in den abhängigen Ansprüchen beschrieben.

Eine vorteilhafte Weiterbildung des Gegenstandes ist, dass der mindestens eine Graben der Tiefenstruktur ein Verhältnis von Tiefe zu Breite von maximal 100 : 1, vorzugsweise von 30 : 1 bis 5 : 1, vor dem Aufbringen des mindestens einen Kondensators aufweist.

Durch ein derartiges Verhältnis von Tiefe zu Breite der Gräben lässt sich die Oberfläche um bis zu einen Faktor 60 bis 200 vergrößern. Dabei ist das Verhältnis so gewählt, dass das Substrat keine zu starke Schwächung erfährt und Prozesse zum Aufbringen der Kondensatoren in der Tiefenstruktur in einem effizienten Bereich operieren können.

Die Tiefe der Gräben ist abhängig von der Substratdicke. Die Substratdicke ist üblicherweise zwischen 500 µm bis 700 µm, kann jedoch in besonderen Fällen auch lediglich 30 µm bis 300 µm betragen. Bei der Herstellung der Kondensatorgräben sind Aushöhlungen zwischen 30 bis 80 % der Substratdicke angemessen. Die Aushöhlungen können mittels Ätzen oder mit anderen im Stand der Technik bekannten Verfahren abgetragen werden.

Insbesondere bei einer Anordnung der Kondensatoren bei einem Substrat mit einer peripheren Kontaktanordnung, bei welcher z.B. Kontaktbumps eingesetzt werden ergibt sich eine Notwendigkeit die Kondensatoranordnung in der Nähe der Kontakte anzuordnen, d.h. entweder daneben oder unter den Kontakten.

Bei einer üblichen Flächenanordnung der Kontakte ergibt sich ein Raster zwischen den Kontakten von 100-1000µm, so dass eine erste Gruppe von Gräben beispielsweise eine Länge von 80 µm bis 950 µm aufweisen könnte. Bei einer zweiten Gruppe, welche zwischen zwei benachbarten Kontakten liegen, könnten bei einer Breite der Gräben zwischen 5 µm bis 500 µm, vorzugsweise von 10 µm bis 100 µm, also zwischen 6 und 100 Gräben nebeneinander liegen. Auf diese Weise könnten höhere Kapazitätswerte als im Stand der Technik erzielt werden ohne die Stabilität des Substrats stark zu gefährden.

Die Anzahl der Gräben in einer Gruppe ist bei bekannter Länge der Gräben vorzugsweise so gewählt, dass die Gruppe im Wesentlichen die Form eines Rechtecks, vorzugsweise eines Quadrats, aufweist. Auf diese Weise wird der zur Verfügung stehende Raum insbesondere in Verbindung mit alternierenden Ausrichtungen der ersten und zweiten Gruppe bestmöglich ausgenutzt. Das Verhältnis von Länge zu Breite eines einzelnen Grabens ist mindestens 3:1, vorzugsweise mindestens 10:1, besonders vorzugsweise mindestens 50:1.

In einer alternativen Ausführung der Halbleiteranordnung könnten die erste und die zweite Gruppe auch Gräben lediglich einer Ausrichtung, d.h. im Wesentlichen parallel zueinander aufweisen.

Eine weitere vorteilhafte Weiterbildung der Halbleiteranordnung ist, dass die schrägen Seitenwände der Gräben verschiedene Winkel zwischen 45° und 90° mit der planaren Rückseite des Substrats bilden. Die Wahl des Winkels hängt dabei vom verwendeten Herstellungsverfahren der Gräben und insbesondere vom Herstellungsverfahren des Kondensators ab. Manche Verfahren erlauben beispielsweise nicht das Abscheiden von Kondensatormaterial auf sehr steilen Seitenwänden, so dass der Winkel prozesstechnisch bedingt kleiner ausfallen muss. Weniger etablierte Prozesse erlauben das Abscheiden von Material auch in steilen oder tiefen Strukturen wie Gräben oder Löchern. Dabei sind technologische Ausführungsformen für eine Niedertemperatur-Prozessführung unter 400°C oder sogar unter 200°C industriell verfügbar.

Eine weitere vorteilhafte Weiterbildung des erfindungsgemäßen Gegenstandes ist es, wenn der aufgebrachte Kondensator sich über mehrere Gräben hinweg erstreckt.

Eine weitere vorteilhafte Anordnung ist dadurch gegeben, dass zwischen der Vorderseite und der Rückseite des Substrats eine Durchkontaktierung vorhanden ist. Dadurch ergibt sich eine besonders effiziente und schnelle Möglichkeit den auf der Rückseite angebrachten Stützkondensator mit der integrierten Schaltung auf der Vorderseite zu verbinden. Dies verhindert einen hohen Spannungsabfall über die Versorgungszuleitungen. Vorteilhafterweise werden die Durchkontaktierungen im gleichen Arbeitsschritt wie die Gräben bzw. Kondensatoren eingebracht. Durch den Flachenanteil der Öffnungen und derer Geometrie ergeben sich unterschiedliche Ätzraten. Bei gleicher Ätzzeit wird durch eine große Maskenöffnung schneller geätzt als durch eine kleinere Maskenöffnung. Für eine Durchkontaktierung wird eine größere Maskenöffnung als für die Gräben gewählt. Bei einer runden Maskenöffnung für eine Durchkontaktierung mit einer Querschnittsfläche A, sind die Maskenöffnungen der Gräben kleiner als A, wobei die Länge des Grabens sehr viel größer als der Durchmesser der runden Maskenöffnung sein kann; die größere Länge wird durch eine schmalere Breite ausgeglichen. Auf diese Weise werden die Durchkontaktierungen bis zur Frontseite geätzt, die Gräben weisen je nach Querschnittsfläche lediglich ein Tiefe von 30% bis 80%, z.B. 70% der Substratdicke auf.

Eine weitere vorteilhafte Weiterbildung der Erfindung ist es, dass der Kondensator schichtartig aus mindestens drei Schichten aufgebaut ist, wobei zumindest eine Schicht durch ein Dielektrikum zwischen mindestens zwei leitenden Schichten gebildet wird. Der schichtartige Aufbau eignet sich, um den mindestens einen Kondensator kostengünstig herzustellen.

Das Dielektrikum ist vorteilhaft aus Siliziumnitrid oder einem Oxid, beispielsweise Silizium- oder Tantaloxid, hergestellt, wobei eine typische Schichtdicke zwischen 40 und 400nm liegt. Die erste und/oder zweite leitende Schicht sind vorzugsweise aus einer Aluminiumlegierung oder Kupfer oder Wolfram.

Es ist weiterhin vorteilhaft, wenn sich die Schichten des Kondensators nicht nur in den Gräben erstrecken, sondern auch über diese hinaus angebracht werden und insbesondere außerhalb des Grabens kontaktierbar sind.

Eine vorteilhafte Weiterbildung des Gegenstandes ist es, dass eine erste leitende Schicht des Kondensators an mindestens einer Wand des mindestens einen Grabens aufgebracht wird und das Dielektrikum auf der ersten leitenden Schicht aufgebracht wird und eine zweite leitende Schicht auf dem Dielektrikum aufgebracht ist. Diese Weiterbildung ist insbesondere dann vorteilhaft, wenn die erste leitende Schicht die gesamte Oberfläche eines Grabens bedeckt, wobei gegebenenfalls zwischen der Oberfläche des Grabens und der ersten leitenden Schicht eine Passivierungsschicht zur Isolation aufgebracht ist. Dadurch kann sich zum einen der Abstand der Kondensatorplatten zueinander verringern, und zum anderen die Kondensatorfläche über die gesamte Oberfläche eines Grabens erstrecken.

Eine andere vorteilhafte Ausführung der Halbleiteranordnung ist es, wenn eine leitende Schicht des Kondensators entlang zumindest einer Wand eines Grabens der Tiefenstruktur aufgebracht ist und eine zweite Schicht an einer der ersten Wand beabstandeten weiteren Wand des mindestens einen Grabens aufgebracht ist. Ein Vorteil einer derartigen Halbleiteranordnung ist es, dass in jedem Graben einer Tiefenstruktur zwei sich gegenüberliegende leitende Schichten, welche jeweils durch ein Dielektrikum, wie zum Beispiel ein Nitrid, ein Oxid, eine organische bzw. polymerbasierte Verbindung oder auch Luft, von einander elektrisch isoliert sind, einen Kondensator aufbauen. Dabei sind die unterschiedlich gepolten Schichten sich gegenseitig gegenüberliegend auf verschiedenen Grabenwänden aufgebracht. Hierbei ist es besonders vorteilhaft, wenn die beiden sich gegenüberliegenden Grabenwände die beiden Wände mit der größten Fläche darstellen.

Im Folgenden soll noch auf das erfindungsgemäße Verfahren eingegangen werden.

Gemäß dem erfindungsgemäßen Verfahren wird in die Rückseite eines Substrats, wobei auf der Vorderseite eine integrierte Schaltung vorhanden ist, mindestens ein Graben eingebracht. Dadurch wird die zur Verfügung stehende Oberfläche zur Bildung von Pufferkondensatoren vergrößert. In einem weiteren Schritt wird eine erste leitende Schicht des mindestens einen Kondensators in den mindestens einen Graben aufgebracht, auf die wiederum eine dielektrische Schicht und eine zweite leitende Schicht des mindestens einen Kondensators in mindestens einem Graben aufgebracht werden.

Bei dem Herstellungsverfahren werden sämtliche Arbeiten zum Einbringen und Ankontaktieren der Gräben von der Rückseite des Substrats durchgeführt. Dies hat unter anderem den Vorteil, dass die Vorderseite des Substrats nicht mit einer später zu entfernenden Opferschicht belegt werden muss. Dies ist insbesondere dann vorteilhaft, wenn die Gräben und die Durchkontaktierungen im selben Arbeitsschritt hergestellt werden. Hierbei werden die bei der Herstellung der integrierten Schaltung aufgebrachten Schichten benutzt, um den Ätzangriff direkt unter den vorhandenen Kontaktflächen der Schaltung zu stoppen. Die Durchkontaktierungen bleiben daher permanent und nicht lediglich temporär geschlossen. Von daher kann auf eine vorderseitige Opferschicht zum Schutz der Schaltung verzichtet werden, da sämtliche Strukturierungsprozesse der Gräben und der Durchkontaktierungen von der Rückseite her durchgeführt werden.

Durch ein derartiges Herstellungsverfahren lässt sich eine Platz sparende, kostengünstige Struktur herstellen. Des Weiteren wird dadurch gesichert, dass die Vorteile, wie in den vorherigen Absätzen beschrieben, der Halbleiteranordnung innewohnen.

Ein besonders vorteilhafte Herstellung der Gräbenanordnung lässt sich mit Hilfe des anisotropen ionenunterstützten Trockenätzens oder des lasergestützten Ätzens realisieren.

Vorteilhafte Weiterbildungen des erfindungsgemäßen

Verfahrens sind in den nebengeordneten Ansprüchen des Verfahrens beschrieben.

Im Folgenden soll die Erfindung anhand eines Ausführungsbeispieles beschrieben werden. Es zeigen:
- Fig. 1: Querschnitt einer erfindungsgemäßen Halbleiteranordnung,
- Fig. 2: Aufsicht auf die Rückseite einer erfindungsgemäßen Halbleiteranordnung,
- Fig. 3: alternative Anordnung von Leiterbahnen,
- Fig. 4: Querschnitt einer alternativen erfindungsgemäßen Halbleiteranordnung;
- Fig. 5: Ausschnitt einer Rückseite mit einer Ausführungsform einer erfindungsgemäβen Halbleiteranordnung;
- Fig. 6: Querschnitt einer Ausführungsform einer erfindungsgemäßen Halbleiteranordnung.

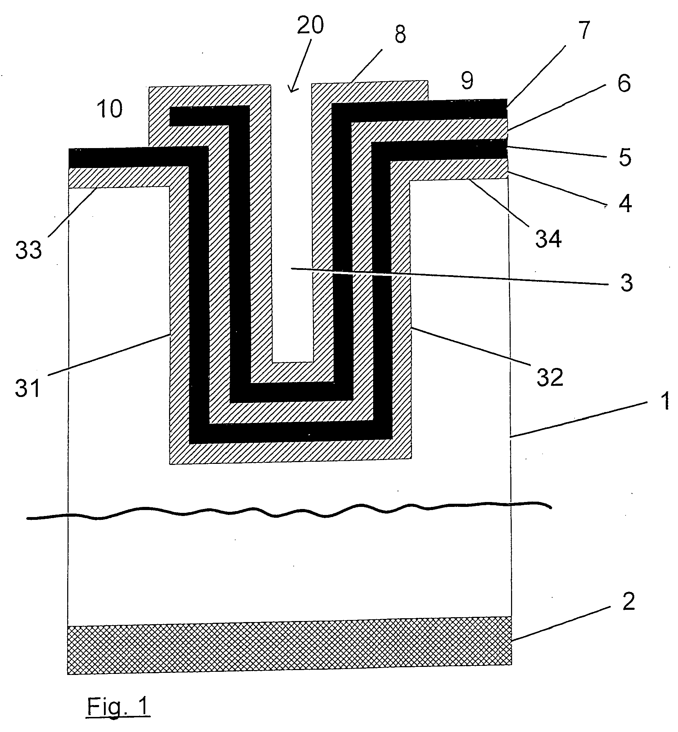

Die Figur 1 zeigt einen Ausschnitt einer Ausführungsform einer erfindungsgemäßen Halbleiteranordnung im Querschnitt. Diese weist ein Substrat 1 auf, auf dessen Vorderseite eine integrierte Schaltung 2 angeordnet ist. Auf der Rückseite befindet sich ein Kondensator 20, welcher aus mehreren Schichten 4 bis 8 aufgebaut ist. Der schichtartige Kondensator 20 verläuft dabei entlang der Oberfläche der Rückseite des Substrats 1, welches eine Tiefenstruktur mit einem Graben 3 aufweist. Dabei ist der Kondensator 20 mit dem Substrat als monolithische Tiefenstruktur ausgebildet.

Zur Herstellung des Kondensators 20 wird zuerst in das Substrat 1 von der Rückseite her mindestens ein Graben 3 eingebracht. Direkt auf der Oberfläche der Rückseite des Substrats 1 mit Graben 3 ist eine Passivierungsschicht 4 angeordnet. Diese verläuft entlang der planaren Oberfläche 33 der Rückseite des Substrats 1 und entlang der geraden Wände 31 und 32 des Grabens 3 und außerhalb des Grabens wieder entlang der planaren Oberfläche 34 des Substrats 1.

Auf die Passivierungsschicht 4 wird eine leitende Schicht 5 aufgebracht. Durch eine darauf abgeschiedene dielektrische Schicht 6 wird die leitende Schicht 5 von einer leitenden Schicht 7 getrennt. Dadurch kann zwischen der leitenden Schicht 5 und der leitenden Schicht 7 eine Kapazität aufgebaut werden, welche über Zuleitungen der Schaltanordnung 2 auf der Vorderseite des Substrats 1 zur Verfügung gestellt werden kann. Zum Aufbringen der verschiedenen Schichten können verschiedene chemische oder physikalische Abscheidungsverfahren verwendet werden wie beispielsweise die anorganische oder metallorganische Gasphasenabscheidung, Sputtern, Aufdampfen oder elektrolytische Abscheidungen.

Anhand der Fig. 1 ist gut erkennbar, wie das Aufbringen einer Tiefenstruktur mit einem Graben 3 bzw. mehreren Gräben 3, welche aus Gründen der Übersichtlichkeit nicht eingezeichnet sind, die Oberfläche eines Kondensators um ein Vielfaches vergrößern kann. Im Gegensatz zu einer planaren Anordnung, kann mit Hilfe der Gräben eine weitaus größere Oberfläche erreicht werden.

Die Vergrößerung der Oberfläche hängt dabei im Wesentlichen von den Ausmaßen eines Grabens 3 ab. Hierbei ist es mit den momentanen Technologien möglich, Grabenbreiten von etwa 10µm bis in eine Tiefe von über 200 µm zu realisieren, wodurch eine Oberflächenvergrößerung um den Faktor 40 erreicht werden kann. Weitere Steigerungen der Oberflächenvergrößerung sind durch tiefere Gräben realisierbar, so dass sich mindestens ein Faktor 100 erreichen lässt.

Für eine Kontaktierung werden die leitenden Schichten über den Rand des Grabens hinaus auf die Oberfläche der Rückseite des Substrats aufgebracht, wobei eine weitere Passivierungsschicht als Schutz und Isolierung auf die zweite leitende Schicht aufgebracht ist. Die erste leitende Schicht 5 wird über den Bereich 10 kontaktiert, die leitende Schicht 7 über den Bereich 9.

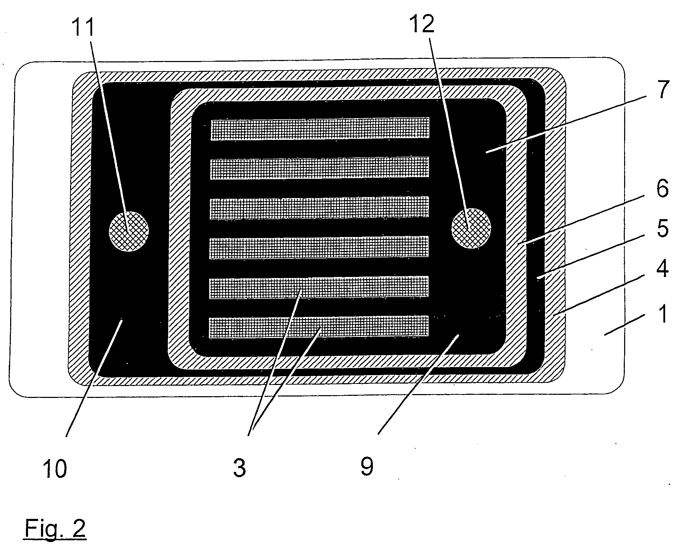

In Figur 2 ist die Rückseite eines weiteren Ausführungsbeispiels in Aufsicht gezeigt, wobei die monolithische Tiefenstruktur mit mehreren parallel angeordneten Gräben 3 realisiert ist. Die Gräben der Fig. 2 bilden eine erste Gruppe 21.

Im Bereich monolithischer Lösungen kann sich die Tiefenstrukturierung in vielfacher Weise unterscheiden. Es können sowohl Gräben als auch Löcher hergestellt werden, die sich in Form und Neigung der Seitenwände weiter unterscheiden können. Die konkrete Ausführungsform kann dabei durch die Prozessführung bedingt sein, z. B. durch den Einsatz nasschemischer Verfahren oder aber andererseits durch eine bewusste Steuerung der Ätzparameter, z. B. im anisotropen ionenunterstützten Trockenätzen sowie durch die Gestaltung der Ätzmaske. Die Motivation für eine bewusste Einstellung der Seitenwand-Neigung kann in einer daraus resultierenden besseren Kontrolle der nachfolgenden Schichtabscheidung liegen. Es sind jedoch auch Methoden bekannt, welche eine konforme Abscheidung in tiefen Strukturen wie Gräben und Löchern erlauben, insbesondere die Abscheidung auf senkrechten Wänden, wie in Fig. 1 gezeigt. Zusätzlich zu den vorbenannten Verfahren sind weitere mögliche Verfahren die plasmaunterstützte chemische Gasphasen-Abscheidung (PEVCD), die Heißdraht-unterstützte chemische Gasphasen-Abscheidung (HWCVD) und das Gasfluß-Sputtern.

In Fig. 2 verlaufen die Schichten 4 bis 7 flächig entlang aller Grabenwände der Gräben 3. Der Verlauf innerhalb eines einzelnen Grabens 3 ist dabei wie in Figur 1 gezeigt. Dabei sind verschiedene nebeneinander liegende Gräben über die planaren Abschnitte 33, 34 miteinander verbunden. Insbesondere ist diese Ausführung der erfindungsgemäßen Halbleiteranordnung besonders einfach realisierbar, wenn die Schichten 4 bis 7 nach dem Aufbringen der Tiefenstruktur - in Form der Gräben 3 - jeweils einschichtig und nacheinander aufgetragen werden. Grundsätzlich können auch mehrere Kondensatoren auf der Rückseite des Substrats angeordnet werden. Dabei erstreckt sich ein Kondensator nur über eine Teilmenge der vorhandenen Gräben. Die verschiedenen Kondensatoren können dann getrennt voneinander angesprochen werden oder zu einem Kondensator verschaltet werden.

Des Weiteren sind in Fig. 2 schematische Durchkontaktierungen 11 und 12 eingezeichnet. Die Durchkontaktierung 11 verbindet die leitende Schicht 5 mit der Vorderseite des Substrats. Analog dazu verbindet die Durchkontaktierung 12 die leitende Schicht 7 mit der Vorderseite des Substrats 1. Des Weiteren können die Durchkontaktierungen 11 und 12 während des Einbringens der Gräben realisiert werden. Die Ausmaße der Durchkontaktierungen sind zur Deutlichkeit stark vergrößert dargestellt.

Zur Herstellung der Gräben und der Durchkontaktierungen sind gängige Verfahren möglich. Insbesondere das Trockenätzen, vorteilhafterweise das anisotrope ionengestützte Trockenätzen, eignet sich zum Aufbringen der Durchkontaktierungen bzw. der Gräben selber. Auch lasergestützte Ätzverfahren sind hierfür denkbar.

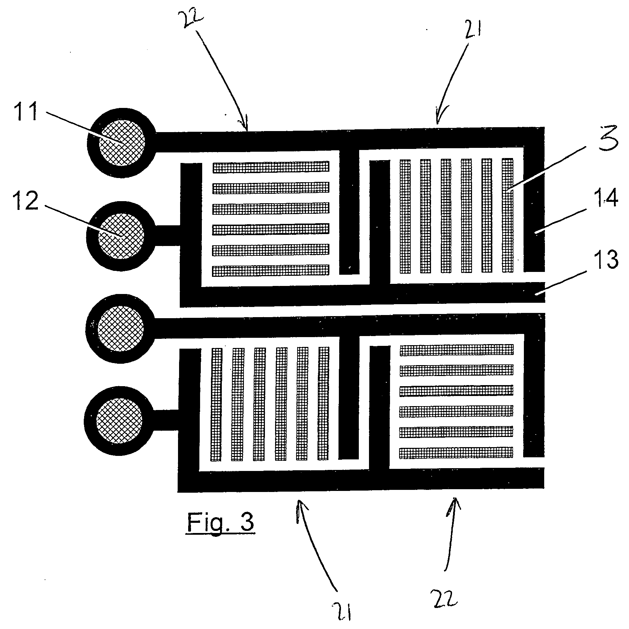

In Figur 3 ist eine Tiefenstruktur mit Gräben gezeigt, welche aufgrund abwechselnder geometrischer Grabenausführungen die Stabilität des Substrats 1 trotz des Vorhandenseins der Gräben 3 nicht kritisch schwächt. Hierbei sind Gräben gruppiert und in jeweils einer ersten Gruppe 21 parallel bzw. quer zu einer zweiten Gruppe 22 angeordnet.

Dadurch lässt sich auf das Substrat 1 eine Tiefenstruktur einbringen, welche die Stabilität des Substrats selbst nicht gefährdet. Auf die möglichen Ausmaße der einzelnen Gräben wurde bereits in der allgemeinen Beschreibung eingegangen.

Des Weiteren sind Anschlussleiterbahnen 13 und 14 eingezeichnet, welche jeweils zwei der vier schematisch dargestellten Kondensatoren 20 miteinander verbinden und ebenfalls zur elektrischen Verbindung der Kondensatoren 20 mit der auf der Vorderseite des Substrats gelegenen Schaltanordnung 2 dienen können.

Hierbei ist deutlich erkennbar, dass die Gräben 3 der ersten Gruppe 21 und die Gräben 3 der zweiten Gruppe 22 im Wesentlichen senkrecht zueinander ausgebildet sind. Des Weiteren ist das Verhältnis zwischen den Abständen der Durchkontaktierungen 11 und 12 sowie der Größe der jeweiligen Gruppen 21 bzw. 22 dargestellt.

Ein einzelner Kondensator 20 erstreckt sich analog zu Fig. 2 über die gesamte Fläche einer ersten oder zweiten Gruppe.

In dem hier gezeigten Ausführungsbeispiel ist die Tiefenstruktur durch Gräben 3 realisiert. Abhängig von der Stabilität des verwendeten Substrats sind jedoch auch andere Geometrien denkbar. Dazu zählen z.B. Löcher oder konzentrische Kreise. Wie bereits erwähnt kann die Form und Neigung der Seitenwände 31, 32 von der hier gezeigten steilen Ausführung abweichen.

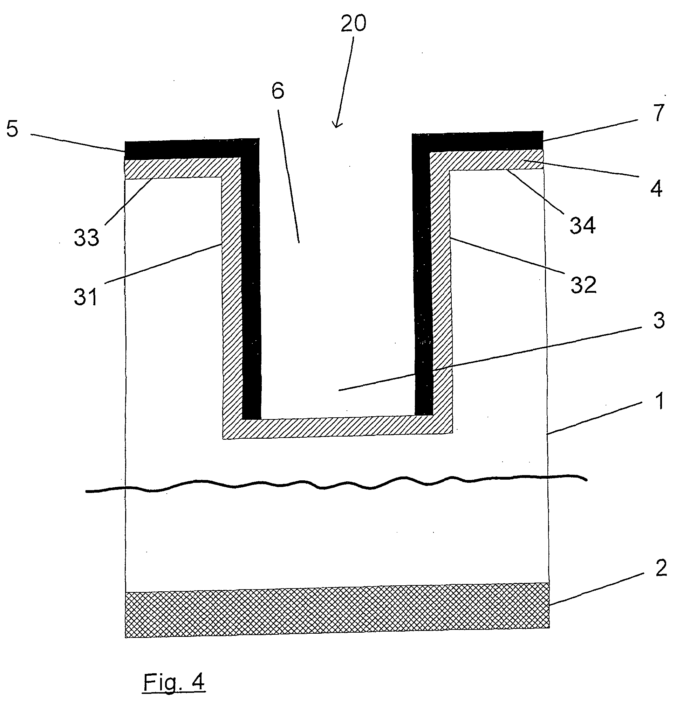

In Fig. 4 ist ein weiteres Ausführungsbeispiel eines Grabens mit einem Kondensator gezeigt. Dabei sind die zwei leitenden Schichten 5, 7 des Kondensators 20 nicht wie in Fig. 1 aufeinander angeordnet, sondern jeweils an verschiedenen sich gegenüberliegenden Grabenwänden 31 und 32. In diesem Beispiel besteht das Dielektrikum 6 aus einer Luftschicht. Selbstredend können auch andere Materialien als Dielektrikum verwendet werden.

Das Ausführungsbeispiel in Fig. 4 kann durch Auftragen eines leitfähigen Materials in den fertigen Graben 3 hergestellt werden. Nach dem Auftragen des leitfähigen Materials wird dieses in zwei separate Bereiche 5, 7 getrennt, beispielsweise durch Ätzen eines Teils des leitfähigen Materials. Allerdings können die leitfähigen Schichten 5, 7 auch separat auf die beabstandeten Wände 31, 32 abgeschieden werden.

Bei Vorhandensein von einer Vielzahl von Gräben 3 können die leitfähigen Schichten 5 und 7 mehrerer oder aller Gräben miteinander verbunden werden, und angestrebte große Kapazität des Kondensators auf diese Weise realisiert werden.

Als Substratmaterial für die Halbleiteranordnung bieten sich Wafer an, z.B. aus Silizium oder Silizumgermanium oder anderen bekannten Halbleitern.

Die beschriebenen Lösungen haben den Vorteil einer erhöhten Integrationsdichte gegenüber einer diskreten Realisierung auf Baugruppenebene.

Die Gräben können im selben Prozessschritt wie die Durchkontaktierungen hergestellt werden, was eine Herstellung der erfindungsgemäßen Anordnung mit gängigen Methoden kostengünstig erlauben würde. Hierbei kann bei guter Prozesskontrolle eine kapazitive Anpassung der Kondensatoren an die integrierte Schaltung erfolgen, wenn der Kondensator z. B. als Filter eingesetzt wird.

Die hier gezeigten Ausführungsformen sind insbesondere bei Bauteilen interessant, die einen hohen Bedarf an Puffer- und Filterkapazitäten haben und in stark miniaturisierten Anwendungen, wie der Mobilkommunikation, zum Einsatz kommen. Solche Bauteile sind insbesondere Mikrokontroller und digitale Signalprozessoren. Auch in Bildsensoren ist der Einsatz von Vorteil, vor allem wenn diese im selben Prozessablauf mit Kondensatoren und mit Durchkontaktierungen versehen werden, da dies eine besonders effiziente Aufbautechnik in der Baugruppenfertigung ermöglicht.

Ein weiteres Einsatzfeld sind Ladungspumpen, in denen durch abwechselnde Parallel- und Reihenschaltung von Kapazitäten eine niedrige Eingangsspannung in eine höhere Ausgangsspannung überführt wird.

Mit den oben erwähnten Abmessungen eines Grabens mit einer Länge von 250 µm bis 950 µm, einer Breite von 10 µm bis zu 100 µm und einer Tiefe von 200 µm bis 500 µm, können unter Verwendung einer Aluminiumlegierung als erste und zweite leitende Schicht und unter der Verwendung eines Siliziumoxids als Dielektrikum, wobei die Schichtdicke des Dielektrikums zwischen 10 nm bis 400 nm liegt und die mindestens drei Schichten übereinander gem. Fig. 1 angeordnet werden, eine Kapazität von 600 pF/mm^2 bis 22.000 pF/mm^2, d.h. bei einer Fläche von 0.1065 mm^2 bis 1.145 mm^2 pro Graben (im Vgl. zu 0.0025 mm^2 bis 0.095 mm^2 bei einer konventionellen Anordnung) eine Kapazität von 64 pF bis 25,2 nF pro Graben erreicht werden. Dies ergibt bei einer Anzahl von 10 bis 50 Gräben pro Gruppe eine Kapazität von etwas mehr als 640 pF bis zu mehr als 1.25 µF je Gruppe. Die Stützkondensatoren können somit Kapazitäten über eine großen Bereich zu Verfügung stellen, je nach Abmessungen und Anzahl der Gräben.

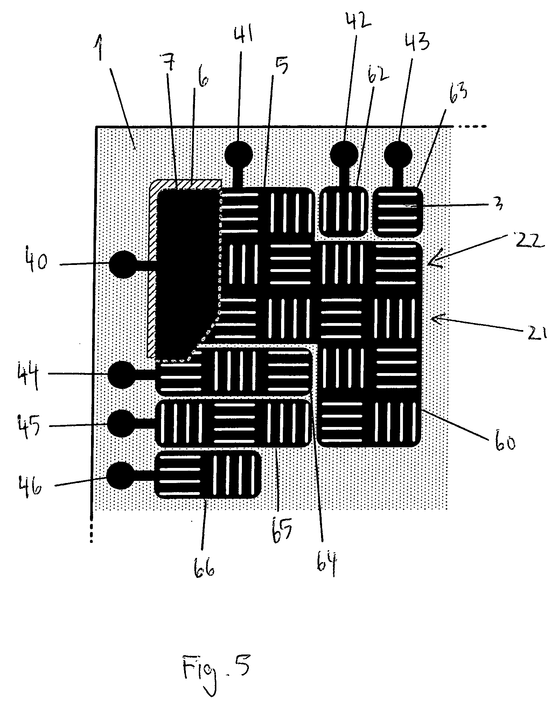

In Fig. 5 wird ein Ausschnitt der Rückseite eines Substrats 1' gezeigt. Auf der Vorderseite des Substrats ist eine komplexe integrierte CMOS-Schaltung angeordnet. Mittels der Durchkontaktierungen 40,41,42,43,44,45,46 wird die auf der Vorderseite vorhandene integrierte Schaltung mit der Rückseite elektrisch kontaktiert.

Der in Fig. 5 dargestellte Ausschnitt zeigt eine Ecke des Substrats mit einer peripheren Anordnung der Kontakte. Weiterhin sind zahlreiche Gräben in Form von ersten und zweiten Gruppen 51,52 gezeigt, wobei die Gräben und teilweise die Zwischenräume zwischen den Gräben einer Gruppe mit einer ersten leitenden Schicht 5 versehen sind. Auf dieser ersten leitenden Schicht 5 ist eine dielektrische Schicht 6 aufgedampft, welche aus Gründen der Übersichtlichkeit nur in einem Teilbereich 53 des Substrats eingezeichnet ist. Gleiches gilt für die zweite leitende Schicht 7, welche ebenfalls nur als Ausschnitt dargestellt ist. Sowohl die dielektrische Schicht 6 als auch die zweite leitende Schicht sind jedoch korrespondierend auf der ersten leitenden Schicht 5 angeordnet. Die zweite leitende Schicht ist dabei durchgängig und mit einem Masseanschluss versehen

Die Vielzahl von ersten und zweiten Gruppen von Gräben wird mit Kondensatoren überzogen, wobei ein Kondensator in einer oder in mehreren Gruppen angeordnet ist. Der Kondensator 60 umfasst siebzehn erste und zweite Gruppen (drei sind durch die eingezeichnete dielektrische Schicht 6 überdeckt), wobei die Zahl beliebig gesteigert werden kann. Der Kondensator 60 ist mit den Durchkontaktierungen 40,41 verbunden, welche den Masseanschluss und den Anschluss für die Versorgungsspannug für eine CMOS-Schaltung der Vorderseite bilden. Der Kondensator 60 weist eine große Kapazität in Bereich der vorhergehenden Abschnitte auf, um die Versorgungsspannung ausreichend zu puffern.

Die Kondensatoren 61, 62 umfassen jeweils nur eine erste bzw. zweite Gruppe. Sie sind ebenfalls mit dem Masseanschluss des Kondensators 60 verbunden: Die zweite elektrisch leitende Schicht 7 übergreift sowohl die erste leitende Schicht 5 des Kondensators 60 als auch der anderen Kondensatoren 62 bis 66, ist jedoch nur im Ansatz in der linken oberen Ecke zu sehen und außerhalb dieser freigeschnitten dargestellt. Die Kondensatoren 61, 62 haben eine geringere Kapazität als der Kondensator 60 und sind jeweils mit Durchkontaktierungen 42, 43 verbunden, welche Oszillatoreingänge darstellen. Wie eingangs erwähnt sind die benötigten Kapazitäten für Oszillatoreingänge geringer als bei der Versorgungsspannung einer z.B. CMOS-Schaltung.

Die Kondensatoren 64, 65 sind mit den Durchkontaktierungen 44, 45 verbunden, welche digitale I/O Kontakte sind. Die Kapazitätsanforderung ist geringer als beim Kondensator 60, jedoch größer als beim Kondensator 62 bzw. 63. Der Kondensator 66 ist mit der Durchkontaktierung 46 verbunden, welche einen analogen Eingang bildet. Die Kapazität bewegt sich zwischen den Kapazitäten der Kondensatoren 64 und 62.

Wie in einem der vorhergehenden Abschnitte bereits beschrieben, werden die Löcher für die Durchkontaktierungen im gleichen Arbeitsschritt wie die Gräben der ersten und zweiten Gruppen angefertigt.

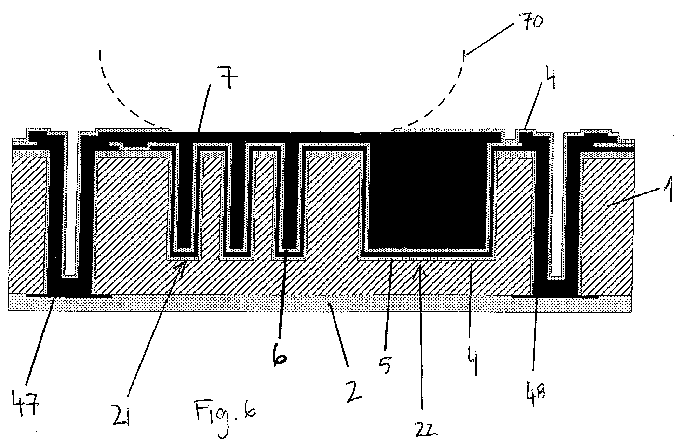

Die Fig. 6 zeigt den Querschnitt durch eine Anordnung von Kondensatoren, welche in einer ersten Gruppe 21 und einer zweiten Gruppe 22 gruppiert sind. Auf der ersten und zweiten Gruppe ist ein Kontaktbump 70 in Form einer Lotkugel aufgebracht. Die Gräben sowohl der ersten als auch der zweiten Gruppe sind beim Aufbringen der zweiten leitenden Schicht 7 völlig geschlossen worden. Auf diese Weise wird eine geschlossene Oberfläche zum Ankontaktieren der Lotkugel geschaffen. Links und rechts der Gräben sind Durchkontaktierungen 47,48 sichtbar, welche bis zur Vorderseite des Substrats reicht und die Schaltung 2 kontaktiert. Die Durchkontaktierung 47 ist ein Masseanschluss, die Durchkontaktierung 48 eine Versorgungsspannung. Die Durchkontaktierung 48 ist mit der ersten leitenden Schicht 5, die Durchkontaktierung 47 mit der zweiten leitenden Schicht 7 verbunden. Weiterhin sind eine dielektrische Schicht 6 und eine Passivierungsschicht 4 eingezeichnet. Die Durchkontaktierungen sind nicht offen sondern geschlossen ausgebildet, d. h. die Schicht der Schaltung 2, welche eine oder mehrere CMOS-Schaltungen aufweist wird beim Einbringen der Durchkontaktierungen nicht angegriffen oder durchstoßen, sondern lediglich ankontaktiert. Dies führt dazu, dass keine Opferschicht auf der Vorderseite des Substrats zum Schutze der Schaltung 2 aufgebracht werden muss.

## Patentansprüche

1. Halbleiteranordnung mit einer auf einem Substrat (1) angeordneten integrierten Schaltung (2), wobei die integrierte Schaltung (2) auf der Vorderseite des Substrats strukturiert ist und mindestens ein Kondensator (20) mit der integrierten Schaltung (2) verbunden ist und der mindestens eine Kondensator auf der Rückseite des Substrats (1) als monolithische Tiefenstruktur in Gräben (3) ausgebildet ist, **dadurch gekennzeichnet, dass** diese Gräben (3) in einer ersten Gruppe (21) von parallelen Gräben und einer zweiten Gruppe (22) von parallelen Gräben angeordnet sind, wobei die Gräben der zweiten Gruppe (22) quer, vorzugsweise senkrecht, zu den Gräben der ersten Gruppe (11) angeordnet sind.

2. Halbleiteranordnung nach Anspruch 1, **dadurch gekennzeichnet, dass** die Gräben (3) eine Tiefe und eine Breite aufweisen, wobei das Verhältnis der Tiefe zur Breite maximal 100 zu 1, vorzugsweise zwischen 30 zu 1 und 5 zu 1, beträgt.

3. Halbleiteranordnung nach Anspruch 1 oder 2, **dadurch gekennzeichnet, dass** die Gräben (3) Seitenwände (31, 32) aufweisen, wobei die Seitenwände einen Winkel im Bereich zwischen 45° und 90°, vorzugsweise im Wesentlichen 90°, mit einer planaren Oberfläche (33, 34) des Substrats bilden.

4. Halbleiteranordnung nach einem der vorhergehenden Ansprüche, **dadurch gekennzeichnet, dass** der mindestens eine Kondensator (20) sich über mindestens zwei Gräben (3) erstreckt und in diesen mindestens zwei Gräben (3) ausgebildet ist.

5. Halbleiteranordnung nach einem der vorhergehenden Ansprüche, **dadurch gekennzeichnet, dass** mindestens eine Durchkontaktierung (11, 12) zwischen der Vorderseite und der Rückseite des Substrats für den elektrischen Anschluss des mindestens einen Kondensators ausgebildet ist.

6. Halbleiteranordnung nach einem der vorhergehenden Ansprüche, **dadurch gekennzeichnet, dass** der mindestens eine Kondensator (20) aus mindestens drei Schichten (4, 5, 6, 7, 8) aufgebaut ist, wobei zumindest eine Schicht durch ein zwischen zwei leitenden Schichten (5,7) angeordnetes Dielektrikum (6) gebildet ist.

7. Halbleiteranordnung nach einem der vorhergehenden Ansprüche, **dadurch gekennzeichnet, dass** die erste leitende (5) und/oder die zweite leitende Schicht (7) des Kondensators zur Bildung von Anschlussflächen (9, 10) die Ränder mindestens eines Grabens (3) übergreifen.

8. Halbleiteranordnung nach einem der vorhergehenden Ansprüche, **dadurch gekennzeichnet, dass** die erste leitende Schicht (5) des Kondensators auf der gesamten Oberfläche mindestens eines Grabens (3) aufgebracht ist, gegebenenfalls mit einer zwischen Graben und erster leitender Schicht aufgebrachten Passivierungsschicht (4), das Dielektrikum (6) auf der ersten leitenden Schicht (5) angeordnet ist und eine zweite leitende Schicht (7) auf dem Dielektrikum (6) angeordnet ist.

9. Verfahren zur Herstellung von Halbleiteranordnungen, wobei die Halbleiteranordnung ein Substrat (1) aufweist und auf der Vorderseite des Substrats (1) eine integrierte Schaltung (2) vorhanden ist, wobei die Vorderseite keine Opferschicht aufweist, und die Rückseite des Substrats (1) eine Tiefenstruktur mit Gräben (3) und mindestens einem Kondensator (20) aufweist, welches folgende Schritte aufweist:
a) Einbringen von Gräben (3) in die Rückseite des Substrats (1), wobei diese Gräben (3) in Form einer ersten Gruppe (21) von parallelen Gräben und einer zweiten Gruppe (22) von parallelen Gräben eingebracht werden und die Gräben der zweiten Gruppe (22) quer, vorzugsweise senkrecht, zu den Gräben der ersten Gruppe (21) angeordnet werden;
b) Aufbringen mindestens eines Kondensators (20) in die erste Gruppe (21) und in die zweite Gruppe (22).

10. Verfahren zur Herstellung von Halbleiteranordnungen, wobei die Halbleiteranordnung ein Substrat (1) aufweist und auf der Vorderseite des Substrats (1) eine integrierte Schaltung (2) vorhanden ist, wobei die Vorderseite keine Opferschicht aufweist, und die Rückseite des Substrats (1) eine Tiefenstruktur mit Gräben (3) und mindestens einem Kondensator (20) aufweist, welches folgende Schritte aufweist:
a) Einbringen von mindestens zwei Gräben (3) in die Rückseite des Substrats (1), wobei eine erste Gruppe (21) von parallelen Gräben und eine zweite Gruppe (22) von parallelen Gräben eingebracht werden und die Gräben der zweiten Gruppe (22) quer, vorzugsweise senkrecht, zu den Gräben der ersten Gruppe (21) angeordnet werden;
b) Aufbringen mindestens eines Kondensators (20) in die erste Gruppe (21) und in die zweite Gruppe (22).

11. Verfahren nach Anspruch 9, **dadurch gekennzeichnet, dass** der mindestens eine Kondensator (20) schichtartig aufgebaut wird und die Schichten auf das mit den Gräben (3) versehene Substrat (1) abgeschieden werden.

12. Verfahren nach einem der Ansprüche 9 oder 10, **dadurch gekennzeichnet, dass** zwischen der integrierten Schaltung (2) auf der Vorderseite des Substrats (1) und dem mindestens einen Kondensator (20) auf der Rückseite des Substrats (1) mindestens eine Durchkontaktierung (11, 12) in das Substrat (1) eingebracht wird, derart dass der mindestens eine Kondensator (20) mit der integrierten Schaltung (2) verbunden wird.

13. Verfahren nach einem der Ansprüche 9 bis 11, **dadurch gekennzeichnet, dass** die Gräben (3) durch Trockenätzen, insbesondere anisotropes ionengestütztes Trockenätzen, oder lasergestützte Ätzverfahren hergestellt werden.

## Claims

1. A semiconductor arrangement with an integrated circuit (2) arranged on a substrate (1), wherein the integrated circuit (2) is structured on the front side of the substrate and at least one capacitor (20) is connected to the integrated circuit (2) and the at least one capacitor is formed on the rear side of the substrate (1) as a monolithic depth structure in trenches (3),
**characterised in that**
these trenches (3) are arranged in a first group (21) of parallel trenches and a second group (22) of parallel trenches, wherein the trenches of the second group (22) are arranged transversely, preferably perpendicularly, to the trenches of the first group (11).

2. A semiconductor arrangement according to claim 1, **characterised in that** the trenches (3) have depth and width, wherein the ratio of the depth to the width is maximally 100 to 1, preferably between 30 to 1 and 5 to 1.

3. A semiconductor arrangement according to claim 1 or 2, **characterised in that** the trenches (3) have side walls (31, 32), wherein the side walls form an angle in the region between 45°and 90°, preferably essentially 90°, with a planar surface (33, 34) of the substrate.

4. A semiconductor arrangement according to one of the preceding claims, **characterised in that** the at least one capacitor (20) extends over at least two trenches (3) and is formed in these at least two trenches.

5. A semiconductor arrangement according to one of the preceding claims, **characterised in that** at least one feedthrough (11, 12) is formed between the front side and the rear side of the substrate, for the electrical connection of the at least one capacitor.

6. A semiconductor arrangement according to one of the preceding claims, **characterised in that** the at least one capacitor (20) is constructed of at least three layers (4, 5, 6, 7, 8), wherein a least one layer is formed by a dielectric (6) arranged between two conductive layers (5, 7).

7. A semiconductor arrangement according to one of the preceding claims, **characterised in that** the first conductive and/or the second conductive layer (7) of the capacitor engage over the edges of at least one trench (3), for forming connection surfaces (9, 10).

8. A semiconductor arrangement according to one of the preceding claims, **characterised in that** the first conductive layer (5) of the capacitor is deposited on the whole surface of at least one trench (3), as the case may be, with a passivation layer (4) deposited between trenches and the first conductive layer, the dielectric (6) is arranged on the first conductive layer, and a second conductive layer (7) is arranged on the dielectric (6).

9. A method for manufacturing semiconductor arrangements, wherein the semiconductor arrangement comprises a substrate (1), and an integrated circuit (2) is present on the front side of the substrate (1), wherein the front side has no sacrificial layer, and the rear side of the substrate (1) has a depth structure with trenches (3) and at least one capacitor (20), which comprises the following steps:
a) incorporating trenches (3) into the rear side of the substrate (1), wherein these trenches are introduced in form of a first group (21) of parallel trenches and a second group (2) of parallel trenches, and the trenches of the second group (22) are arranged transversely, preferably perpendicularly to the trenches of the first group (21);
b) depositing at least on capacitor (20) into the first group (21) and into the second group (22).

10. A method for manufacturing semiconductor arrangements, wherein the semiconductor arrangement comprises a substrate (1), and an integrated circuit (2) is present on the front side of the substrate (1), wherein the front side has no sacrificial layer, and the rear side of the substrate (1) has a depth structure with trenches (3) and at least one capacitor (20), which comprises the following steps:
a) incorporating at least two trenches (3) into the rear side of the substrate (1), wherein a first group (21) of parallel trenches and a second group (2) of parallel trenches are introduced and the trenches of the second group (22) are arranged transversely, preferably perpendicularly to the trenches of the first group (21);
b) depositing at least on capacitor (20) into the first group (21) and into the second group (22).

11. A method according to claim 9, **characterised in that** the at least one capacitor (20) is constructed in a layer-like manner, and the layers are deposited onto the substrate (1) provided with the trenches (3).

12. A method according to one of the claims 9 or 10, **characterised in that** at least one feedthrough (1, 12) is introduced into the substrate (1), between the integrated circuit (2) on the front side of the substrate (1) and the at least once capacitor (20) on the rear side of the substrate (1), in a manner such that the at least one capacitor (20) is connected to the integrated circuit (2).

13. A method according to one of the claims 9 to 11, **characterised in that** the trenches (2) are manufactured by way of dry-etching, in particular anisotropic, ion-aided dry etching or laser-aided etching methods.

## Revendications

1. Dispositif à semi-conducteur avec un circuit intégré (2) disposé sur un substrat (1), le circuit intégré (2) étant structuré à l'avant du substrat et au moins un condensateur (20) étant relié avec le circuit intégré (2) et l'au moins un condensateur étant réalisé à l'arrière du substrat (1) sous la forme d'une structure de profondeur monolithique en sillons (3), **caractérisé en ce que**
ces sillons (3) sont disposés dans un premier groupe (21) de sillons parallèles et un deuxième groupe (22) de sillons parallèles, les sillons du deuxième groupe (22) étant disposés transversalement, de préférence perpendiculairement, par rapport aux sillons du premier groupe (11).

2. Dispositif à semi-conducteur selon la revendication 1, **caractérisé en ce que** les sillons (3) présentent une profondeur et une largeur, le rapport entre la profondeur et la largeur étant au maximum de 100 pour 1, de préférence entre 30 pour 1 et 5 pour 1.

3. Dispositif à semi-conducteur selon la revendication 1 ou 2, **caractérisé en ce que** les sillons (3) présentent des parois latérales (31, 32), les parois latérales formant un angle entre 45° et 90°, de préférence globalement 90°, avec une surface plane (33, 34) du substrat.

4. Dispositif à semi-conducteur selon l'une des revendications précédentes, **caractérisé en ce que** l'au moins un condensateur (20) s'étend sur au moins deux sillons (3) et est formé dans ces au moins deux sillons (3).

5. Dispositif à semi-conducteur selon l'une des revendications précédentes, **caractérisé en ce qu'**au moins une traversée (11, 12) est formée entre l'avant et l'arrière du substrat pour la connexion électrique de l'au moins un condensateur.

6. Dispositif à semi-conducteur selon l'une des revendications précédentes, **caractérisé en ce que** l'au moins un condensateur (20) est constitué d'au moins trois couches (4, 5, 6, 7, 8), au moins une couche étant formée d'un diélectrique (6) disposé entre deux couches conductrices (5, 7).

7. Dispositif à semi-conducteur selon l'une des revendications précédentes, **caractérisé en ce que** la première couche conductrice (5) et/ou la deuxième couche conductrice (7) du condensateur recouvrent les bords d'au moins un sillon (3) pour la formation de surfaces de connexion (9, 10).

8. Dispositif à semi-conducteur selon l'une des revendications précédentes, **caractérisé en ce que** la première couche conductrice (5) du condensateur est appliquée sur toute la surface d'au moins un sillon, le cas échéant avec une couche de passivation (4) appliquée entre le sillon et la première couche conductrice, le diélectrique (6) est disposé sur la première couche conductrice (5) et une deuxième couche conductrice (7) est disposée sur le diélectrique (6).

9. Procédé de fabrication de dispositifs semi-conducteurs, le dispositif semi-conducteur comprenant un substrat (1) et un circuit intégré (2) se trouvant à l'avant du substrat (1), l'avant ne comprenant aucune couche sacrificielle et l'arrière du substrat (1) présentant une structure en profondeur avec des sillons (3) et au moins un condensateur (20), qui comprend les étapes suivantes :
a) réalisation de sillons (3) à l'arrière du substrat (1), ces sillons (3) étant réalisés sous la forme d'un premier groupe (21) et d'un deuxième groupe (22) de sillons parallèles et les sillons du deuxième groupe (22) étant disposés transversalement, de préférence perpendiculairement, aux sillons du premier groupe (21) ;
b) insertion d'au moins un condensateur (20) dans le premier groupe (21) et dans le deuxième groupe (22).

10. Procédé de fabrication de dispositifs semi-conducteurs, le dispositif semi-conducteur comprenant un substrat (1) et un circuit intégré (2) se trouvant à l'avant du substrat (1), l'avant ne comprenant aucune couche sacrificielle et l'arrière du substrat (1) présentant une structure en profondeur avec des sillons (3) et au moins un condensateur (20), qui comprend les étapes suivantes :
a) réalisation d'au moins deux sillons (3) à l'arrière du substrat (1), un premier groupe (21) de sillons parallèles et un deuxième groupe (22) de sillons parallèles étant réalisés et les sillons du deuxième groupe (22) étant disposés transversalement, de préférence perpendiculairement, aux sillons du premier groupe (21) ;
b) insertion d'au moins un condensateur (20) dans le premier groupe (21) et dans le deuxième groupe (22).

11. Procédé selon la revendication 9, **caractérisé en ce que** l'au moins un condensateur (20) présente une structure en couches et les couches sont déposées sur le substrat (1) muni des sillons (3).

12. Procédé selon l'une des revendications 9 ou 10, **caractérisé en ce que**, entre le circuit intégré (2), à l'avant du substrat (1), et l'au moins un condensateur (20), à l'arrière du substrat (1), est réalisée au moins une traversée (11, 12) dans le substrat (1), de façon à ce que l'au moins un condensateur (20) soit relié avec le circuit intégré (2).

13. Procédé selon l'une des revendications 9 à 11, **caractérisé en ce que** les sillons (3) sont réalisés par gravure sèche, plus particulièrement une gravure sèche anisotrope par ions ou un procédé de gravure au laser.
